# EUROPEAN PATENT APPLICATION

(11) **EP 3 989 439 A1**
(43) Date of publication of application: **27.04.2022**
(21) Application number: 19933458.2
(22) Date of filing: 23.09.2019
(51) Int. Cl.: H03H 3/02, H03H 9/02

(54) **ACOUSTIC WAVE DEVICE, AND PREPARATION METHOD THEREFOR AND TEMPERATURE CONTROL METHOD THEREOF**

(30) Priority: 20.06.2019 CN 201910539094
(71) Applicant: Hangzhou Sappland Microelectronics Technology Co., Ltd., Hangzhou, Zhejiang 310015 (CN)
(72) Inventor: ZHANG, Shumin, Hangzhou, Zhejiang 310015 (CN); WANG, Guohao, Hangzhou, Zhejiang 310015 (CN); WANG, Quan, Hangzhou, Zhejiang 310015 (CN); CHEN, Hailong, Hangzhou, Zhejiang 310015 (CN); ZHENG, Genlin, Hangzhou, Zhejiang 310015 (CN)
(74) Representative: Romano, Giuseppe
(86) International application number: PCT/CN2019/107203
(87) International publication number: WO 2020/252962

(57) **Abstract**

An acoustic wave device and a preparation method therefor, and a temperature control method of the acoustic wave. The preparation method comprises: respectively providing a first substrate and a second substrate (S110); forming an acoustic wave structure and a temperature measuring resistor on the first substrate (S120, S130); forming a TEC device on the second substrate (S140); and carrying out metal melting bonding on the first substrate and the second substrate to complete the preparation of the acoustic wave device (S150). In addition, by adjusting an actual temperature in the acoustic wave device by means of a heating or cooling effect of the TEC device, the temperature control of the acoustic wave device is realized, and the acoustic wave device has a stable working temperature.

## Description

### FIELD

The present disclosure relates to a microelectronic device, and more particularly to an acoustic wave device, a method for producing an acoustic wave device and a method for controlling temperature of an acoustic wave device.

### BACKGROUND

With the development of wireless communication applications, people's requirements for data transmission rate is increasingly high, such that a utilization rate of spectrum resources becomes higher and a communication protocol becomes more complicated, correspondingly. In order to meet the requirements on the data transmission rate, it is necessary to fully utilize the spectrum, and a carrier aggregation technology is also used since 4G to enable a device to simultaneously use different carrier spectrums to transmit data. In addition, in order to support a sufficient data transmission rate within a limited bandwidth, the communication protocol becomes more complicated, and the requirements for various performances of a radio frequency (RF) system become stricter.

An RF filter plays a vital role in an RF front-end module, because it can filter interference and noise out of band to meet the requirements of the RF system and the communication protocol for the signal-to-noise ratio. With the complication of the communication protocol, the requirements in the frequency band and out of the frequency band are becoming higher, and with the increase of data streams received and transmitted in mobile phones, more filters that can handle higher frequency signals with low energy consumption are needed. For the RF filter and a resonator that constitutes the filter, it is required to have a better frequency temperature coefficient. The closer the frequency temperature coefficient is to zero, the smaller the effect of temperature on the performance of the acoustic wave device is, and the better the filtering performance of the acoustic wave device is.

At present, it is difficult in the related art to achieve a zero temperature coefficient in a whole temperature range, and the existing acoustic wave devices have a limited power tolerance. When the input power increases, the temperature of the device will increase due to its limited heat dissipation, which results in drift and nonlinearity of the frequency of the device, thereby greatly affecting the performance of the device. Therefore, it is necessary to provide an acoustic wave device with a good temperature stability.

### SUMMARY

Embodiments of the present disclosure seek to solve at least one of the problems existing in the related art to at least some extent. For this, an acoustic wave device, a method for producing an acoustic wave device and a method for controlling temperature of an acoustic wave device are provided.

In a first aspect of the present disclosure, a method for producing an acoustic wave device is provided. The method includes steps:
S110: providing a first substrate and a second substrate;
S120: forming an acoustic wave structure on the first substrate;
S130: forming a temperature measuring resistor on the first substrate;
S140: forming a TEC (thermoelectric cooler) device on the second substrate; and
S150: bonding the first substrate and the second substrate via metal fusion to produce the acoustic wave device.

Alternatively, in the step S120, the acoustic wave structure includes a radio frequency bulk acoustic wave structure, and the radio frequency bulk acoustic wave structure includes: a lower electrode, a piezoelectric layer and an upper electrode sequentially formed on the first substrate; an air gap between the first substrate and the lower electrode; a lower electrode lead-out wire penetrating through the piezoelectric layer and electrically connected to the lower electrode; and an upper electrode lead-out wire electrically connected to the upper electrode.

Alternatively, in the step S120, the acoustic wave structure includes a radio frequency bulk acoustic wave structure, and the radio frequency bulk acoustic wave structure includes: a lower electrode, a piezoelectric layer and an upper electrode sequentially formed on the first substrate; a Bragg reflective grating between the first substrate and the lower electrode; a lower electrode lead-out wire penetrating through the piezoelectric layer and electrically connected to the lower electrode; and an upper electrode lead-out wire electrically connected to the upper electrode.

Alternatively, in the step S120, the acoustic wave structure includes a radio frequency bulk acoustic wave structure, and the radio frequency bulk acoustic wave structure includes: a lower electrode, a piezoelectric layer and an upper electrode sequentially formed on the first substrate; a deep channel penetrating through the first substrate and corresponding to the lower electrode; a lower electrode lead-out wire penetrating through the piezoelectric layer and electrically connected to the lower electrode; and an upper electrode lead-out wire electrically connected to the upper electrode.

Alternatively, the step S130 includes:
forming a metal layer on the first substrate; and
alternatively, subjecting the metal layer to lithography to form a Pt temperature measuring resistor.

Alternatively, the step S150 includes:
forming and patterning a metal film for bonding on the first substrate to form a plurality of primary bonding bumps;
forming and patterning a metal film for bonding on the second substrate to form a plurality of secondary bonding bumps and a plurality of metal via holes;
electrically connecting the temperature measuring resistor and the acoustic wave structure to corresponding metal via holes through some of the primary bonding bumps; and
bonding the first substrate and the second substrate via metal fusion through the others of the primary bonding bumps and corresponding secondary bonding bumps to produce the acoustic wave device.

Alternatively, the first substrate is provided with six primary bonding bumps, which are a first primary bonding bump, a second primary bonding bump, a third primary bonding bump, a fourth primary bonding bump, a fifth primary bonding bump and a sixth primary bond bump;
the second substrate is provided with two secondary bonding bumps, which are a first secondary bonding bump and a second secondary bonding bump, and four metal via holes, which are a first metal via hole, a second metal via hole, a third metal via hole and a fourth metal via hole;
the first primary bonding bump and the sixth primary bond bump are located at two ends of the first substrate in a length direction, and correspond to the first secondary bonding bump and the second secondary bonding bump, respectively;
the second primary bonding bump and the third primary bonding bump are disposed on the temperature measuring resistor, and correspond to the first metal via hole and the second metal via hole, respectively;
the fourth primary bonding bump is disposed on the lower electrode lead-out wire, and corresponds to the third metal via hole; and
the fifth primary bonding bump is disposed on the upper electrode lead-out wire, and corresponds to the fourth metal via hole.

Alternatively, in the step S150, the metal film is formed of TiW/Au, Cr/Au, Cu, Sn or Ag.

In a second aspect of the present disclosure, an acoustic wave device is provided. The acoustic wave device is produced by the above-mentioned method.

In a third aspect of the present disclosure, a method for controlling temperature of an acoustic wave device is provided. The TEC device includes a first current port and a second current port, the temperature measuring resistor includes a first temperature measuring electrode and a second temperature measuring electrode, and the second substrate is provided with a first metal via hole and a second metal via hole.

The first temperature measuring electrode is electrically connected to the first metal via hole, and the second temperature measuring electrode is electrically connected to the second metal via hole; the first current port is electrically connected to a first electrode of a precision voltage source, the second current port is electrically connected to a second electrode of the precision voltage source, a control electrode of the precision voltage source is electrically connected to an output terminal of a microcontroller, a first input terminal of the microcontroller is electrically connected to the first metal via hole, and a second input terminal of the microcontroller is electrically connected to the second metal via hole.

The method for controlling temperature of the acoustic wave device includes steps:
S110': measuring an actual temperature in the acoustic wave device based on a temperature measuring circuit of the temperature measuring resistor to judge whether the actual temperature reaches a preset temperature, if yes, stopping temperature adjustment, if no, executing step S120';
S120': adjusting a magnitude and polarity of a voltage output by the precision voltage source using the microcontroller according to the actual temperature in the acoustic wave device; and
S130': heating or cooling a side of the acoustic wave device by the TEC device according to the polarity of the voltage output by the precision voltage source; and controlling a heating or cooling capacity according to the magnitude of the voltage output by the precision voltage source, and repeating the step S110'.

The present disclosure produces an acoustic wave device with a TEC temperature adjustment device and a temperature measuring resistor. By combining the Peltier effect of the TEC device with the Pt temperature measuring resistor, the acoustic wave device may be cooled or heated to control the temperature, which greatly improves the frequency temperature coefficient of the acoustic wave device, and the temperature control accuracy can reach 0.01 degrees at most, such that the acoustic wave device has a stable working temperature and a stable performance, which greatly improve a power capacity of the acoustic wave device.

### BRIEF DESCRIPTION OF THE DRAWINGS

FIG. 1 is a flow chart of a method for producing an acoustic wave device of the present disclosure;
FIG. 2 is a schematic diagram showing step 1 of a method for producing an acoustic wave device according to a first embodiment of the present disclosure;
FIG. 3(a) to FIG. 3(c) are schematic diagrams showing step 2 of a method for producing an acoustic wave device according to a first embodiment of the present disclosure;
FIG. 4 is a schematic diagram showing step 3 of a method for producing an acoustic wave device according to a first embodiment of the present disclosure;
FIG. 5 is a schematic diagram showing step 4 of a method for producing an acoustic wave device according to a first embodiment of the present disclosure;
FIG. 6 is a schematic diagram showing step 5 of a method for producing an acoustic wave device according to a first embodiment of the present disclosure;
FIG. 7 is a schematic diagram showing step 6 of a method for producing an acoustic wave device according to a first embodiment of the present disclosure;
FIG. 8 is a schematic diagram showing step 7 of a method for producing an acoustic wave device according to a first embodiment of the present disclosure;
FIG. 9 is a schematic diagram showing step 8 of a method for producing an acoustic wave device according to a first embodiment of the present disclosure;
FIG. 10 is a schematic diagram showing step 9 of a method for producing an acoustic wave device according to a first embodiment of the present disclosure;
FIG. 11 is a schematic diagram showing electrical connections used for controlling temperature of an acoustic wave device according to a second embodiment of the present disclosure; and
FIG. 12 is a flow chart of a method for controlling temperature of an acoustic wave device according to a second embodiment of the present disclosure.

### DETAILED DESCRIPTION

In order to make those skilled in the art better understand the present disclosure, the present disclosure will be further described in detail below with reference to embodiments and accompanying drawings.

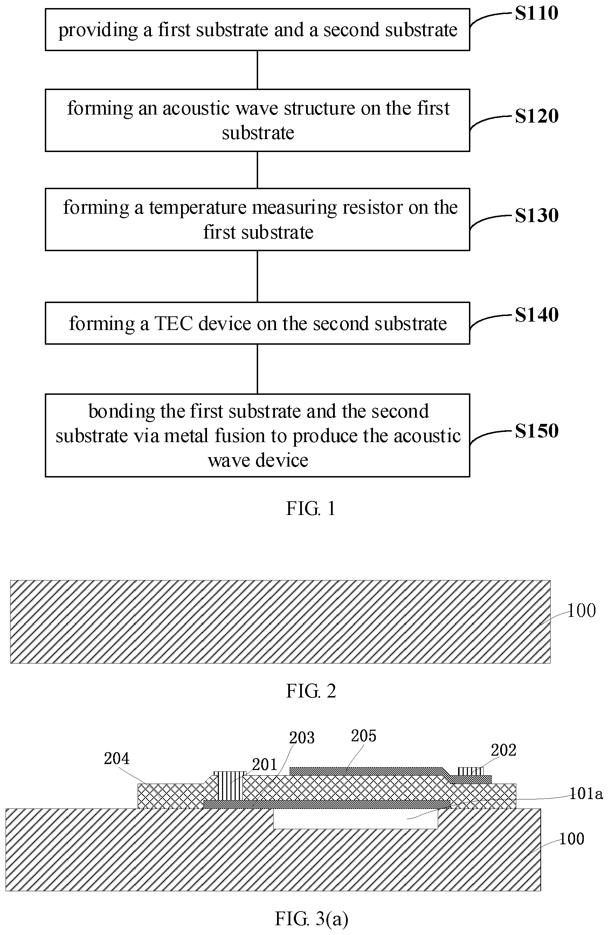

As shown in FIG. 1, in a first aspect of the present disclosure, a method for producing an acoustic wave device is provided. The method includes steps:
S110: providing a first substrate and a second substrate;
S120: forming an acoustic wave structure on the first substrate;
S130: forming a temperature measuring resistor on the first substrate;
S140: forming a TEC device on the second substrate; and
S150: bonding the first substrate and the second substrate via metal fusion to produce the acoustic wave device.

The present disclosure produces an acoustic wave device with a TEC temperature adjustment device and a temperature measuring resistor. By combining the Peltier effect of the TEC device with the Pt temperature measuring resistor, the acoustic wave device may be cooled or heated to control the temperature, which greatly improves the frequency temperature coefficient of the acoustic wave device, and the temperature control accuracy can reach 0.01 degrees at most, such that the acoustic wave device has a stable working temperature and a stable performance, which greatly improve a power capacity of the acoustic wave device.

Detailed descriptions are given below through specific embodiments.

### First embodiment

FIG. 2 to FIG. 10 show a flow chart of a method for producing an acoustic wave device according to a first embodiment of the present disclosure. The method includes steps as follows.

Step 1: a first substrate 100 with single or both faces polished is prepared. The first substrate 100 may be a silicon wafer or a SiC substrate, and has a good thermal conductivity. The polished face is up, and for the first substrate 100 with single face polished, the polished face may be any face of the first substrate, and standard cleaning is performed, as shown in FIG. 2.

Step 2: an acoustic wave structure is formed on the first substrate 100. The acoustic wave structure may be any of the following structures.

In a first example, the acoustic wave structure is a radio frequency bulk acoustic wave structure, which as shown in FIG. 3(a) includes a lower electrode 203, a piezoelectric layer 204, an upper electrode 205, an air gap 101a, a lower electrode lead-out wire 201 and an upper electrode lead-out wire 202. A passivation layer may be provided below the lower electrode 203 and above the upper electrode 205.

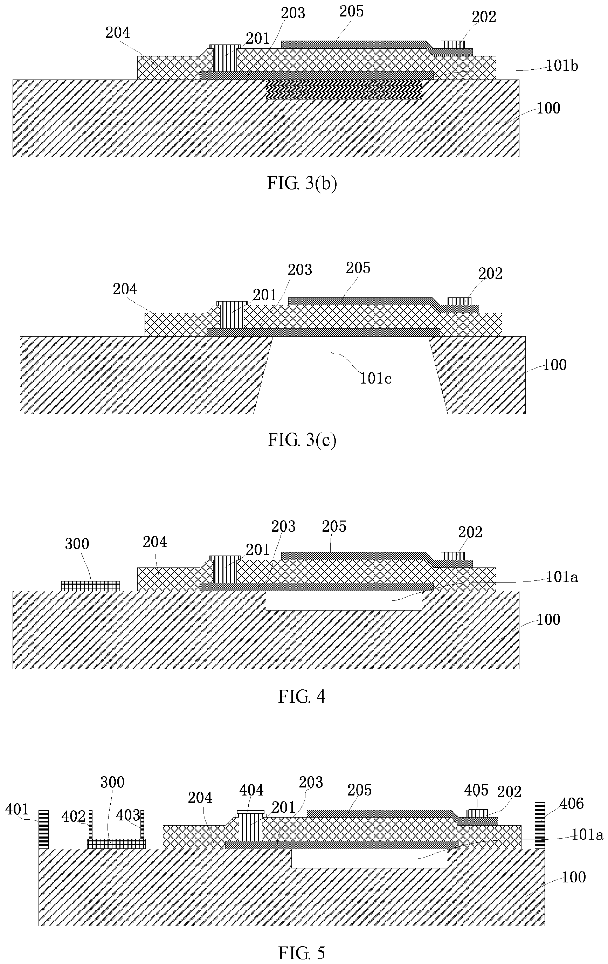

In a second example, the acoustic wave structure is a radio frequency bulk acoustic wave structure, which as shown in FIG. 3(b) includes a lower electrode 203, a piezoelectric layer 204, an upper electrode 205, a Bragg reflective grating 101b, a lower electrode lead-out wire 201 and an upper electrode lead-out wire 202. A passivation layer may be provided above the upper electrode 205.

In a third example, the acoustic wave structure is a radio frequency bulk acoustic wave structure, which as shown in FIG. 3(c) includes a lower electrode 203, a piezoelectric layer 204, an upper electrode 205, a deep channel 101c penetrating through the first substrate, a lower electrode lead-out wire 201 and an upper electrode lead-out wire 202. A passivation layer may be provided below the lower electrode 203 and above the upper electrode 205.

In addition, in addition to the above-mentioned three structures, the acoustic wave structure may also be a radio frequency surface acoustic wave structure, even a filter based on a radio frequency bulk acoustic wave structure or a filter based on a surface acoustic wave structure may be provided on the upper surface of the first substrate 100.

It should be noted that the present disclosure will be further described with reference to the example where the radio frequency bulk acoustic wave structure having the air gap is used as a component of the acoustic wave device. Of course, it is also possible that those skilled in the art may select other specific acoustic wave structures to form the acoustic wave device as needed.

Step 3: a Pt metal layer is deposited on the upper surface of the first substrate 100 and is subjected to lithography to form a Pt temperature measuring resistor 300, as shown in FIG. 4.

Step 4: a metal film for bonding is formed and patterned on the upper surface of the first substrate 100 to form a plurality of primary bonding bumps, which are a first primary bonding bump 401, a second primary bonding bump 402, a third primary bonding bump 403, a fourth primary bonding bump 404, a fifth primary bonding bump 405 and a sixth primary bond bump 406. As shown in FIG. 5, the second primary bonding bump 402 and the third primary bonding bump 403 are used as two temperature measuring electrodes of the Pt temperature measuring resistor 300. The metal film for bonding may be formed of TiW/Au, Cr/Au, Cu, Sn, Ag and the like.

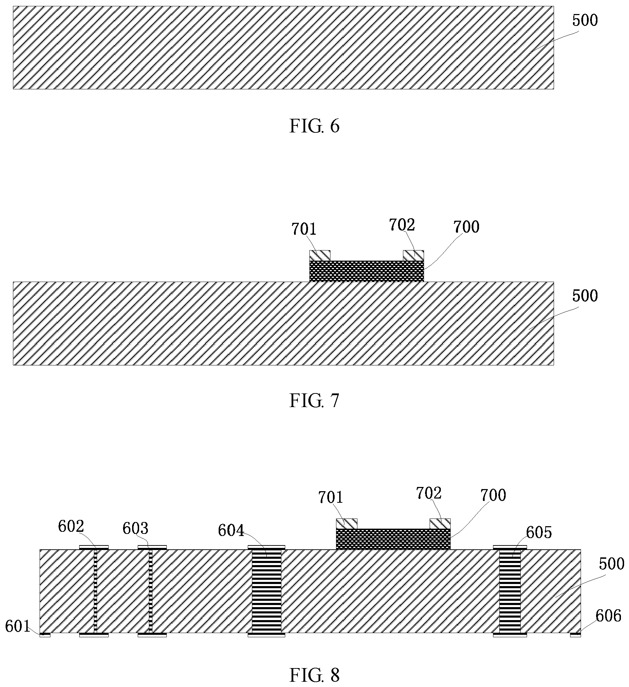

Step 5: a second substrate 500 with single or both faces polished is prepared. The second substrate 500 may be a silicon wafer or a SiC substrate, and has a good thermal conductivity. The polished face is up, and for the second substrate 500 with single face polished, the polished face may be any face of the second substrate, and standard cleaning is performed, as shown in FIG. 6.

Step 6: a TEC device 700 is adhered to an upper surface of the second substrate 500 by an adhesive with good electrical insulation and thermal conductivity. As shown in FIG. 7, the TEC device 700 includes a first current port 701 and a second current port 702.

Step 7: the second substrate 500 is subjected to deep-etching and is coated with a metal to form a plurality of metal via holes, which are a first metal via hole 602, a second metal via hole 603, a third metal via hole 604 and a fourth metal via hole 605, and a first secondary bonding bump 601 and a second secondary bonding bump 606, as shown in FIG. 8.

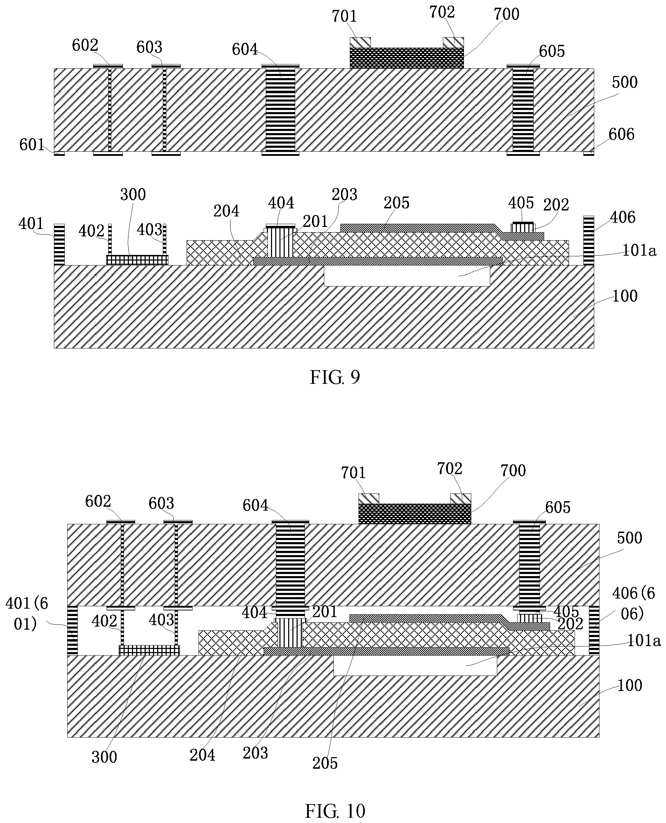

Step 8: as shown in FIG. 9, the first substrate 100 and the second substrate 500 are aligned.

Step 9: the first substrate 100 and the second substrate 500 are bonded via metal fusion to produce the acoustic wave device, as shown in FIG. 10.

In this embodiment, the materials for making the upper electrode and the lower electrode of the piezoelectric sandwich structure of the acoustic wave device may be the same or different, which for example may include any one or any combinations of the followings: tungsten, silver, zirconium, molybdenum, platinum, ruthenium, iridium, titanium tungsten, copper, titanium, chromium, hafnium, aluminum. The material for making the piezoelectric layer may be aluminum nitride, lithium niobate, lithium tantalate, lead zirconate titanate, zinc oxide, lithium tetraborate, or a doped film or a combination thereof.

In a second aspect of the present disclosure, an acoustic wave device is provided, which is produced by the above-mentioned method. The acoustic wave device has a TEC device and a temperature measuring resistor, which may effectively measure an actual temperature in the acoustic wave device through a temperature measuring circuit of the temperature measuring resistor, and then control the temperature by the TEC device to maintain the temperature stable. For the specific production method of the acoustic wave device, please refer to the previous related description, which will not be repeated here.

In a third aspect of the present disclosure, a method for controlling temperature of an acoustic wave device is provided, which will be illustrated in detail below with reference to the following embodiment.

### Second embodiment

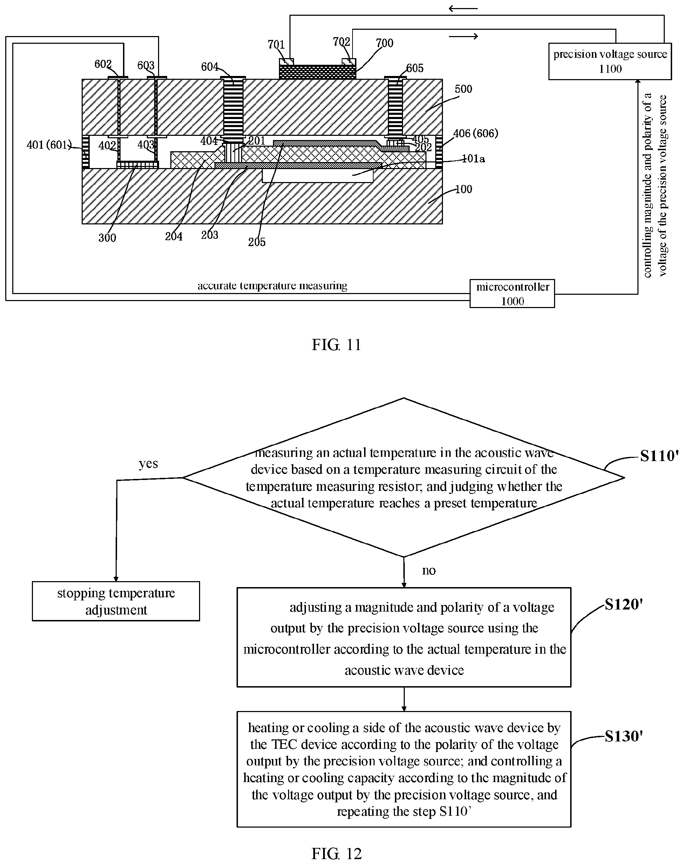

FIG. 11 is a schematic diagram showing electrical connections used for controlling temperature of an acoustic wave device according to a second embodiment of the present disclosure. The TEC device includes a first current port 701 and a second current port 702. The second primary bonding bump 402 and the third main bonding bump 403 are used as a first temperature measuring electrode and a second temperature measuring electrode of the Pt temperature measuring resistor 300, respectively.

The first temperature measuring electrode 402 is electrically connected to the first metal via hole 602, and the second temperature measuring electrode 403 is electrically connected to the second metal via hole 603. The first current port 701 is electrically connected to a first electrode (e.g., a positive electrode) of a precision voltage source 1100, and the second current port 702 is electrically connected to a second electrode (e.g., a negative electrode) of the precision voltage source 1100. A control electrode of the precision voltage source 1100 is electrically connected to an output terminal of a microcontroller 1000, a first input terminal of the microcontroller 1000 is electrically connected to the first metal via hole 602, and a second input terminal of the microcontroller 1000 is electrically connected to the second metal via hole 603, as shown in FIG. 11.

FIG. 12 is a flow chart of the method for controlling temperature of the acoustic wave device according to the second embodiment of the present disclosure. The method includes steps as follows.

S110': an actual temperature in the acoustic wave device is measured based on a temperature measuring circuit of the Pt temperature measuring resistor 300; and it is judged whether the actual temperature reaches a preset temperature, if yes, temperature adjustment is stopped, if no, step S120' is executed.

S120': a magnitude and polarity of a voltage output by the precision voltage source 1100 is adjusted by a microcontroller 1000 according to the comparison between the actual temperature in the acoustic wave device and the preset temperature.

S130': a side of the acoustic wave device is heated or cooled by the TEC device 700 according to a current direction corresponding to the polarity of the voltage output by the precision voltage source 1100, and a heating or cooling capacity of the TEC device 700 is controlled according to a magnitude of a current flowing through the TEC device 700 corresponding to the magnitude of the voltage output by the precision voltage source 1100.

Under the heating or cooling effects of the TEC device 700, the temperature of the acoustic wave device increases or decreases. Based on the actual temperature of the acoustic wave device measured by the temperature measurement circuit of the Pt temperature measuring resistor 300, the above-mentioned step S110' is repeated again for dynamically adjusting the temperature of the acoustic wave device.

In this embodiment, the method for controlling the temperature of the acoustic wave device is described in detail. When the radio frequency input power of the acoustic wave device increases, the generated heat may be removed by the TEC device to control the temperature of the acoustic wave device. Therefore, the actual temperature in the acoustic wave device is adjusted by the heating or cooling effects of the TEC device, such that the acoustic wave device may keep stable in the whole working temperature range, which improves the temperature stability of the device, and greatly improves the power capacity of the acoustic wave device.

It would be appreciated that the above embodiments are merely explanatory embodiments for illustrating the present disclosure, which cannot be construed to limit the present disclosure. For those skilled in the art, various modifications and improvements can be made without departing from the spirit and principles of the present disclosure, and these modifications and improvements are also deemed to be within the scope of the present disclosure.

## Claims

1. A method for producing an acoustic wave device, comprising steps:
S110: providing a first substrate and a second substrate;
S120: forming an acoustic wave structure on the first substrate;
S130: forming a temperature measuring resistor on the first substrate;
S140: forming a TEC device on the second substrate; and
S150: bonding the first substrate and the second substrate via metal fusion to produce the acoustic wave device.

2. The method according to claim 1, wherein in the step S120, the acoustic wave structure comprises a radio frequency bulk acoustic wave structure comprising:
a lower electrode, a piezoelectric layer and an upper electrode sequentially formed on the first substrate;
an air gap between the first substrate and the lower electrode;
a lower electrode lead-out wire penetrating through the piezoelectric layer and electrically connected to the lower electrode; and
an upper electrode lead-out wire electrically connected to the upper electrode.

3. The method according to claim 1, wherein in the step S120, the acoustic wave structure comprises a radio frequency bulk acoustic wave structure comprising:
a lower electrode, a piezoelectric layer and an upper electrode sequentially formed on the first substrate;
a Bragg reflective grating between the first substrate and the lower electrode;
a lower electrode lead-out wire penetrating through the piezoelectric layer and electrically connected to the lower electrode; and
an upper electrode lead-out wire electrically connected to the upper electrode.

4. The method according to claim 1, wherein in the step S120, the acoustic wave structure comprises a radio frequency bulk acoustic wave structure comprising:
a lower electrode, a piezoelectric layer and an upper electrode sequentially formed on the first substrate;
a deep channel penetrating through the first substrate and corresponding to the lower electrode;
a lower electrode lead-out wire penetrating through the piezoelectric layer and electrically connected to the lower electrode; and
an upper electrode lead-out wire electrically connected to the upper electrode.

5. The method according to any one of claims 1 to 4, wherein the step S130 comprises:
forming a metal layer on the first substrate; and
subjecting the metal layer to lithography to form a Pt temperature measuring resistor.

6. The method according to any one of claims 2 to 4, wherein the step S150 comprises:
forming and patterning a metal film for bonding on the first substrate to form a plurality of primary bonding bumps;
forming and patterning a metal film for bonding on the second substrate to form a plurality of secondary bonding bumps and a plurality of metal via holes;
electrically connecting the temperature measuring resistor and the acoustic wave structure to corresponding metal via holes through some of the primary bonding bumps; and
bonding the first substrate and the second substrate via metal fusion through the others of the primary bonding bumps and corresponding secondary bonding bumps to produce the acoustic wave device.

7. The method according to claim 6, wherein the first substrate is provided with six primary bonding bumps, which are a first primary bonding bump, a second primary bonding bump, a third primary bonding bump, a fourth primary bonding bump, a fifth primary bonding bump and a sixth primary bond bump;
the second substrate is provided with two secondary bonding bumps, which are a first secondary bonding bump and a second secondary bonding bump, and four metal via holes, which are a first metal via hole, a second metal via hole, a third metal via hole and a fourth metal via hole;
wherein the first primary bonding bump and the sixth primary bond bump are located at two ends of the first substrate in a length direction, and correspond to the first secondary bonding bump and the second secondary bonding bump, respectively;
the second primary bonding bump and the third primary bonding bump are disposed on the temperature measuring resistor, and correspond to the first metal via hole and the second metal via hole, respectively;
the fourth primary bonding bump is disposed on the lower electrode lead-out wire, and corresponds to the third metal via hole; and
the fifth primary bonding bump is disposed on the upper electrode lead-out wire, and corresponds to the fourth metal via hole.

8. The method according to claim 6, wherein in the step S150, the metal film is formed of TiW/Au, Cr/Au, Cu, Sn or Ag.

9. An acoustic wave device, produced by the method according to any one of claims 1 to 8.

10. A method for controlling temperature of an acoustic wave device according to claim 9, wherein the TEC device comprises a first current port and a second current port, the temperature measuring resistor comprises a first temperature measuring electrode and a second temperature measuring electrode, and the second substrate is provided with a first metal via hole and a second metal via hole;
wherein the first temperature measuring electrode is electrically connected to the first metal via hole, and the second temperature measuring electrode is electrically connected to the second metal via hole; the first current port is electrically connected to a first electrode of a precision voltage source, the second current port is electrically connected to a second electrode of the precision voltage source, a control electrode of the precision voltage source is electrically connected to an output terminal of a microcontroller, a first input terminal of the microcontroller is electrically connected to the first metal via hole, and a second input terminal of the microcontroller is electrically connected to the second metal via hole;
wherein the method for controlling temperature of the acoustic wave device comprises steps:
S110': measuring an actual temperature in the acoustic wave device based on a temperature measuring circuit of the temperature measuring resistor; and judging whether the actual temperature reaches a preset temperature, if yes, stopping temperature adjustment, if no, executing step S120';
S120': adjusting a magnitude and polarity of a voltage output by the precision voltage source using the microcontroller according to the actual temperature in the acoustic wave device; and
S130': heating or cooling a side of the acoustic wave device by the TEC device according to the polarity of the voltage output by the precision voltage source; and controlling a heating or cooling capacity according to the magnitude of the voltage output by the precision voltage source, and repeating the step S110'.
